# EUROPÄISCHE PATENTANMELDUNG

(11) **EP 0 989 504 A1**
(43) Veröffentlichungstag der Anmeldung: **29.03.2000**
(21) Anmeldenummer: 98118274.4
(22) Anmeldetag: 26.09.1998
(51) Int. Cl.: G06F 17/50

(54) **Vorrichtung und Verfahren zur Bereitstellung von variablem Wohnraum**

(71) Anmelder: Haarmann, Norbert, 55124 Mainz (DE)
(72) Erfinder: Haarmann, Norbert, 55124 Mainz (DE)
(74) Vertreter: Kampfenkel, Klaus, Dipl.-Ing.DE)

(57) **Zusammenfassung**

Der vorliegende Erfindungsgegenstand bezieht sich auf eine Vorrichtung zur Aufnahme und Selektion von Gebäudedaten wie beispielsweise Grundrissen von Gebäuden oder Wohnungen und einer dieser Einrichtung zugeordneten Auswerteeinrichtung zur Bestimmung von möglichen Varianten von Wohnraumgrundrissen. In dieser Form wird erstmals eine Vorrichtung vorgestellt, welche über die Verfahrenschritt der Eingabe von Selektionsparametern bzw. Objektparametern, der Darstellung des potentiellen Wohnung und der Angabe der möglichen Grundrißkombinationen, verschiedene Gestaltungsvarianten, insbesondere bei bestehenden Gebäuden, von freiem Nutzraum projiziert, plant und zur Disposition freigibt.

## Beschreibung

Die Erfindung betrifft ein Vorrichtung und ein Verfahren zur Bereitstellung von variablem Wohnraum in Form von digitalen Informationen, Arbeitslisten, Plänen sowie graphische Darstellungen gemäß den Merkmalen der Ansprüche 1 und 13.

Es sind Verfahren bekannt, bei denen flexibler Wohnraum bereitgestellt wird. Diese Verfahren zeichnen sich insbesondere dadurch aus, daß der gestaltbar Wohnraum zunächst im wesentlichen als Leerraum bereitgestellt wird und es dann dem Benutzer überlassen bleibt diese Leerflächen auszufüllen und damit bewohnbar zu machen. D.h. die weitere konzeptionelle Ausgestaltung wird bei diesen Verfahren im wesentlichen ausgeklammert. Zudem lassen sich diese Verfahren prinzipiell nur auf Neubauten oder auf entkernte Altbauten anwenden. Dies bedeutet unter anderem, daß im Rahmen einer Anwendung dieser Verfahren zunächst keine Alternativkonzepte der Verwendung bzw. der Gestaltung in Betracht gezogen werden. Ferner sind diese Verfahren im Prinzip nicht zur selektiven Restaurierung bzw. Umgestaltung von älteren Wohngebäuden geeignet.

Der Erfindung liegt daher die Aufgabe zu Grunde die Nachteile des Standes der Technik zu vermeiden und ein Verfahren und eine Vorrichtung bereitzustellen, welche in integrierter Form für Alt- und Neubauten variablen Wohnraum schnell und kostengünstig bereitstellt.

Die Lösung dieser Aufgabe erfolgt auf höchst überraschende Art und Weise bereits durch die Merkmale der Ansprüche 1 und 13.

Durch eine Einrichtung zur Aufnahme und Selektion von Gebäudedaten wie beispielsweise Grundrissen von Gebäuden oder Wohnungen und einer dieser Einrichtung zugeordneten Auswerteeinrichtung zur Bestimmung von möglichen Varianten von Nutzraumgrundrissen, wird erstmals eine Vorrichtung bereitgestellt, welche über die Verfahrenschritt der Eingabe von Selektionsparametern bzw. Objektparametern, der Darstellung des potentiellen Wohnung und der Angabe der möglichen Grundrißkombinationen umfaßt, verschiedene Gestaltungsvarianten von freiem Nutzraum projiziert, plant und zur Disposition freigegeben werden können.

Vorteilhafterweise umfaßt die erfindungsgemäße Vorrichtung auch eine Eingabeeinrichtung, mittels der Daten von Gebäuden in die Speichereinrichtung eingeben werden können. Die über die Eingabeeinrichtung der Vorrichtung zugänglich gemachten Daten können im wesentlichen nach Wohnobjektparameter und interne Gebäudeparameter unterschieden werden. Wenn im Rahmen der vorliegenden Ausarbeitung von Gebäudeparametern die Rede ist, so sind damit Eingaben hinsichtlich Grundeinstellungen gemeint, durch die die Architektur des umzubauenden Objekts definiert ist. Darunter fallen beispielsweise Angaben zur Anzahl von Stockwerken, dem Vorhandensein von Balkonen und weitere Angaben zu Grundrissen der Stockwerke bzw. der einzelnen Wohneinheiten und vorzugsweise auch solche Informationen die Zwangspunkte betreffen, die bei der Grundrißvariation eine wichtige Rolle spielen und die bei Altbauten im wesentlichen als unverrückbar anzusehen sind. Als wesentliche Randbedingungen bestimmen insbesondere die Zwangspunkte, welche Kombinationen von Grundrissen es grundsätzlich geben kann. Die benannten Grundeinstellungen sind vor der eigentlichen Inbetriebnahme der Vorrichtung zu tätigen und können sehr vorteilhaft im Rahmen der erfindungsgemäßen Vorrichtung beliebig ergänzt bzw. auf diverse Gebäudetypen erstreckt werden. Die Tiefe des Detailierungsgrads kann in nahezu beliebiger Form auf sehr vorteilhafte Weise entweder vom Anbieter der Vorrichtung voreingestellt werden oder vom Benutzer definiert werden. Was wiederum die Anwendungsflexibilität der erfindungsgemäßen Vorrichtung erhöht. Ein wichtiger Aspekt, der insbesondere auch für die Anwendung der Vorrichtung bei Neu- und Altbauten eine nicht zu unterschätzende Bedeutung hat.

Gegenüber den Gebäudeparametern sind solche Eingaben zu unterscheiden, die nach der Pflege der Grundeinstellungen zur Bestimmung des variablen Wohnraum unter Abstimmung mit den Grundeinstellungen gemacht werden. Derartige Parameter werden im Rahmen der vorliegenden Ausarbeitung als Wohnobjektparameter bezeichnet. Diese Parameter dienen der Eingrenzung auf bestimmte Wohnbereiche bzw. auf bestimmte Wohnungen, die einer Umgestaltung bzw. einem Umbau unterzogen werden sollen. Im weitesten Sinne können zu diesen Parameter insbesondere Angaben zur gewünschten Gemeinde bzw. zum gewünschten Ort, dem Gebäude in diesem Ort, dem Wohnungstyp und dessen Ausstattung gehören. Auf diese Weise können auf höchst einfache Weise für den Verwender die bevorzugten Wohnungsvarianten sehr gezielt bestimmt werden. Für den Fachmann ist offensichtlich, daß diese nicht abschließende Aufzählung von Parametern im Rahmen der Erfindung beliebig erweitert werden kann.

In höchst vorteilhafterweise besitzt die erfindungsgemäße Vorrichtung ebenfalls eine Mikroprozessoreinrichtung, durch die die von der Speichereinheit bereitgestellten Gebäudeparameter und Wohnobjektparameter verarbeitet werden. In einer einfachen Ausführungsvariante werden beispielsweise mit bezug auf einen bestimmten Wohnungstyp für ein ausgewähltes Gebäude bereits einige mögliche Grundrißvariationen vordefiniert, auf die die Mikroprozessoreinrichtung zurückgreift und dem Verwender oder der erfindunsgemäßen Vorrichtung selbst, unter Berücksichtigung der eingegebenen Wohnobjektparameter, zur Verfügung bzw. zur Disposition stellt. In einer komplexeren Variante bestimmt die Mikroprozessoreinrichtung mittels den, dann jedoch detaillierter einzugebenden Wohnobjektparametern und Gebäudeparametern, verschiedene Grundrißkombinationen selbständig. Darunter kann beispielsweise die aufgrund der vorgegebenen Daten optimale Wohnfläche verstanden werden und z.B. ferner drei mögliche weitere Alternativen, denen z.B. die Optimierung der Fensterflächen zu Grunde liegt. Die Optimierung nach Wohn- und/oder Fensterflächen würde dann natürlich voraussetzen, daß diese zuvor als Wohnobjektparameter, wie bereits besprochen, in die Eingabeeinrichtung eingegeben wurden.

Ferner weißt die Mikroprozessoreinrichtung der vorliegenden Erfindung den Vorteil auf, daß sie auf der Basis der zuvor bestimmten Grundrißvarianten von beispielsweise einer Wohnung, alle Bestandteile eines bei der planerischen Durchführung eines Umbaus notwendigen Pflichtenheftes bereitzustellen. Diese Teile können unter anderem aus Netzplänen, Stücklisten und dem damit verbunden Auftrag an die in Frage kommenden Handwerker bestehen, so daß in höchst effizienter Form ohne Zeitverlust die Baumaßnahmen unverzüglich in die Wege geleitet werden können. Die entsprechenden Grundeinstellungen sind natürlich zuvor zu definieren, so daß sie im Rahmen der vorzunehmenden Baumaßnahmen auf Grundlage des selektierten Grundrißes ausgewählt werden können. Auf sehr vorteilhafter Weise kann so die erfindungsgemäße Vorrichtung Grundrißkombinationen auf den darauf aufbauenden Umbau-, Neubau oder Anpassungsprozeß abstimmen.

Eine entsprechende Möglichkeit eröffnet die erfindungsgemäße Vorrichtung auch für eventuell, bereits nach der Auswertung des variablen Wohnraums abzuschließende Miet- oder Kaufverträge. Auf vorteilhafte Weise bestimmt die Mikroprozessoreinrichtung, daher die notwendigen Daten für die abzuschließenden Verträge, die mittels der noch zu beschreibenden Ausgabeeinrichtung des Erfindungsgegenstands ausgegeben werden können.

In vorteilhafter Weitergestaltung des vorliegenden Erfindungsgegenstands umfaßt die erfindungsgemäße Vorrichtung auch eine Anzeigeeinrichtung. Die in diesem Zusammenhang architektonische Varianten eines Wohnraums oder einer sonstigen bewohnbaren Fläche in einem Gebäude darstellen und dies beispielsweise sowohl in Form einer zweidimensionalen technischen Zeichnung als auch in einer dreidimensional Projektion aufzeigen und bereitstellen kann. Eine Möglichkeit durch die auf höchst vorteilhafte Weise der Verwender der Vorrichtung einen Überblick über die potentiellen Varianten der Wohnung erhält. Dies schließt natürlich auch das Schaffen eines virtuellen Raums ein. Auf diese Weise kann sich der Verwender der Vorrichtung nahezu lebensnahes Bild vom potentiell zu kaufenden oder zu mietenden Raum machen.

Positiv ist in diesem Zusammenhang auch, daß die erfindungsgemäße Vorrichtung eine oder mehrere bidirektionale Schnittstelle aufweist. Auf diese Weise wird nicht nur die Verbindung zur erfindungsgemäßen Anzeigeeinrichtung geschaffen, sondern auch beispielsweise zu externen Datenbanken und Netzwerken der Außenwelt, die zur Informationsbereitstellung genutzt werden können.

Die Erfindung wird nachfolgend an Hand von Zeichnungen mit bezug auf mehreren Ausführungsbeispielen im Zusammenhang mit den zugeordneten Figuren beschrieben.

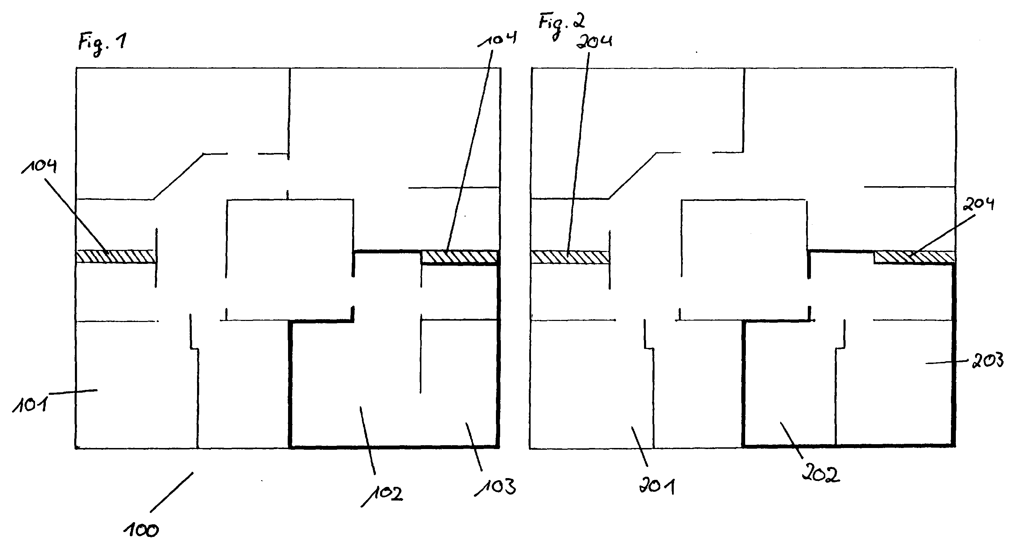

Es zeigen:
Figs. 1 bis 3 schematische Darstellungen von mehreren Grundrißkombinationen auf einer Etage.
Figs. 4 bis 5 schematische Darstellungen einer Grundrißkombination über zwei Etagen
Fig. 6 eine schematische dreidimensionale Darstellung eines Wohnraums.
Fig. 7 schematisch eine mögliche Ablauffolge eines erfindungsgemäßen Verfahrens.
Aus den Figuren 1 und 2 sind beispielhaft zwei Grundrißkombinationen 1 und 2 einer Etage zu entnehmen. Beide Wohnungsgrundrisse sind im Ergebnis auf Vorgaben zurückzuführen, die vom Anwender der erfindungsgemäßen Vorrichtung, als Gebäudeparameter oder Wohnobjektparameter in die selbige voreingestellt bzw. eingegeben wurden. Sie stehen dementsprechend beispielhaft für zwei alternative Entwürfe, die einem potentiellen Käufer oder Mieter dargeboten werden können. Bei genauer Ansicht der Figuren ist zu erkennen, daß die dargestellte Etage im Rahmen einer 2:4 Kombination aufgeteilt wurde. D.h., daß sich eine Vierzimmerwohnung 101 und eine Zweizimmerwohnung 102 auf der Etage gegenüber stehen. Andere Kombinationsmöglichkeit sind für den Fachmann offensichtlich und werden auch nachfolgen noch besprochen. Die vorgestellten Entwürfe berücksichtigen nicht nur den möglichen Wunsch für eine bestimmte Zimmerzahl der Wohnungen, sondern auch Attribute, die sich auf die Aufteilung der Wohnungen beziehen. Beispielhaft sei in diesem Zusammenhang auf die dargestellten Zweizimmerwohnungen 102 und 202 verwiesen. In der Zweizimmerwohnung 102 der Fig. 1 wurde z.B. eine vergleichsweise offene Bauweise als Alternative gegenüber der Zweizimmerwohnung 202 aus Fig. 2 von der erfindungsgemäßen Vorrichtung vorgeschlagen. Man erkennt dabei, daß der Schlafbereich 103 aus Fig. 1 nur durch eine Halbwand gegenüber dem übrigen Bereich abgetrennt wurde. Dagegen wird in Fig. 2 eine vollkommene Aufteilung des Raumes durch eine durchgehende Wand vorgeschlagen, deren freies Ende als Befestigungsfläche für die Türen, der voneinander getrennten Räume, dienen kann. Entsprechende Variationen sind selbstverständlich auch auf dem Hintergrund anderer Attribute, wie z.B. Balkon ja oder nein, abgeschlossene oder offene Küchenräume etc. denkbar und möglich. In diesem Zusammenhang sind natürlich Zwangspunkte wie z.B. Wasser Ab- oder Zuflüsse 104, 204 oder auch Treppenhäuser zu berücksichtigen. Dies gilt insbesondere bei Altbauten, die naturgemäß wesentlich mehr Zwangspunkte aufweisen, die nicht oder nur mit einem sehr großen Kostenaufwand verlegbar sind. Wobei mit bezug auf Neubauten aber auch bei Altbauten angefügt werden muß, daß auch die sogenannten Zwangspunkte eine Optimierung im Rahmen der erfindungsgemäßen Vorrichtung erfahren können, die sich dann wiederum auf die Möglichkeiten der Bestimmung der Grundriß- bzw. Wohnungsvarianten auswirkt. Eine Eingabe der entsprechenden Punkte in die erfindungsgemäße Vorrichtung ist natürlich vorauszusetzen, so daß im Rahmen einer Eingabe von Zielfindungskriterien für die Auswahl potentieller Grundrisse, die sich unter anderem auf funktionale und wirtschaftliche Aspekte der zukünftigen Räumlichkeiten beziehen können, eine entsprechende Selektion und/oder Bestimmung geeigneter Grundrisse erfolgen kann.

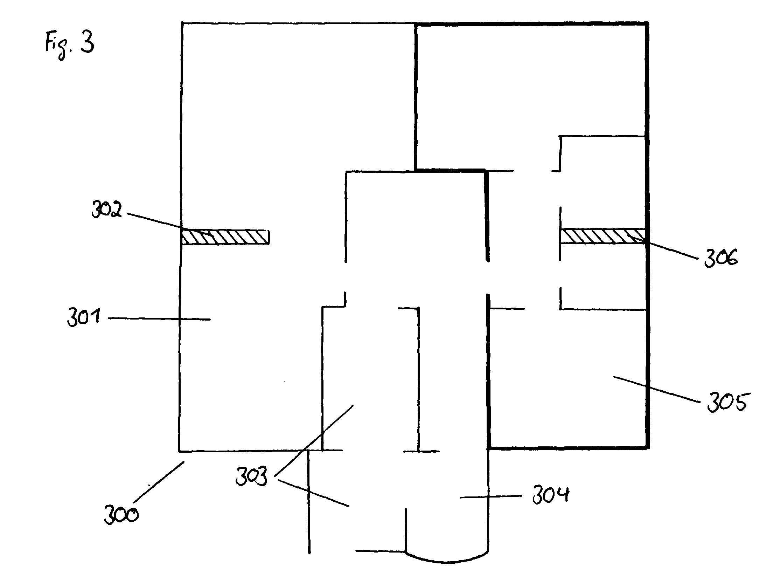

Figur 3 zeigt eine weitere Grundrißvariante 300 einer entsprechenden Etage, wie sie aus den Figuren 1 und 2 zu erkennen ist. Der linke Bereich der Zeichnung zeigt beispielhaft einen noch unfertigen Bereich mit dem Zwangspunkt 302, der über eine Anwendung der erfindungsgemäßen Vorrichtung gestaltet werden kann. In vorteilhafter Ausgestaltung wurden bei dieser Grundrißvariante auch ein möglicher Eingangsbereich 303 und ein Freiraumbereich für einen Außenaufzug 304 berücksichtigt. Die an die Verwenderbedürfnisse ausgerichtete Wohnung 305 umfaßt hierbei insgesamt zwei Zimmer, die mit bezug auf die Rohrleitungsanschlüsse nahezu symmetrisch angeordnet sind. Die Freifläche 301 wäre komplementär zur Wohnung 305 und zum Ausgang- und Aufzugbereich auch in eine Zweizimmerwohnung aufteilbar oder mit beispielsweise einem gemeinsamen Eingang auch als zwei Einzimmerwohnungen gestaltbar. Sollte der rechte Bereich der Etage 305 bereits als Zweizimmerwohnung von der erfindungsgemäßen Vorrichtung projektiert worden sein, so können von der erfindungsgemäßen Vorrichtung geeignete Alternativgrundrisse für den linken Bereich 301 vorgehalten oder bestimmt und diese falls erforderlich oder gewünscht vom Verwender abgerufen werden.

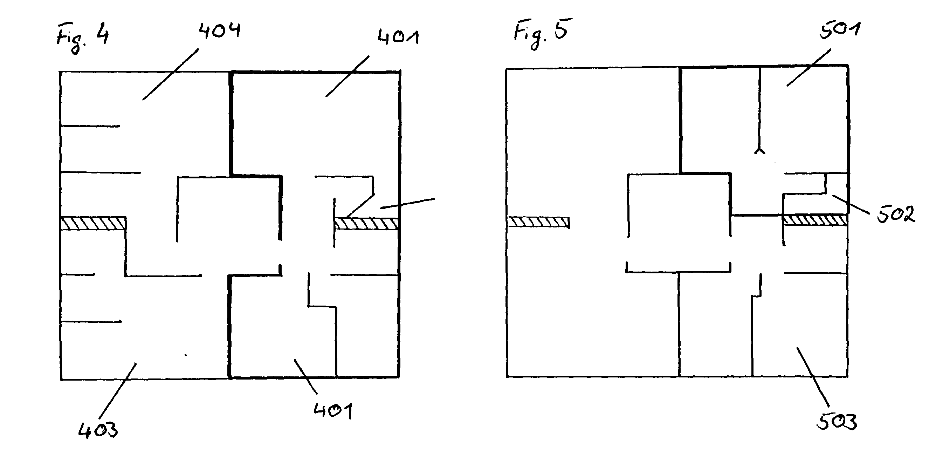

Anhand der Figuren 4 und 5 soll beispielhaft gezeigt werden, daß sich die Grundrißvarianten nicht nur auf eine Etage beziehen müssen. Die erfindungsgemäße Vorrichtung ist vielmehr auch in der Lage eine Wohnungs- bzw. Grundrißplanung über mehrere Ebenen durchzuführen. Aus Figur 4 geht daher eine erste Ebene 401 einer über zwei Ebenen verlaufenden Wohnung hervor. Dabei schließt sich an den großzügig geschnittenen Zweizimmerbereich 401 aus Figur 4 die zweite Ebene mit dem Zweizimmerbereich 501 an. Beide Bereiche sind über den Treppenaufgang 402 bzw. 502 miteinander verbunden. Der linke Bereich 403 und 404 des Grundrisses aus Figur 4 und die erste Ebene 401 der Zweiebenenwohnung 401 und 501 stellen für sich wiederum eine neue Variante bzw. Raumaufteilung der bereits in den Figuren 1 bis 3 beschriebenen Art dar. In diesem Zusammenhang ist insbesondere zu beachten, daß die Wohnungen 403 und 404 sowohl mit bezug auf den Grundriß 401 als auch in sich neue Varianten der Raumaufteilung darstellen. Ferner ist noch zu Figur 5 zu bemerken, daß der an den Wohnbereich 501 anschließenden Wohnbereich 503 dem Grundriß der Wohnung 202 gemäß Figur 2 entspricht, der linke Bereich in Figur 5 ist dagegen noch als gestaltbare Freifläche dargestellt. Es sei in diesem Zusammenhang nochmals darauf hingewiesen, daß es sich bei den beschriebenen Grundrissen im Rahmen der Erfindung nur um einige wenige mögliche Grundrißkombinationen handelt, die die Allgemeinheit der Möglichkeiten der erfindungsgemäßen Vorrichtung nicht beschränken sollen. Wobei zu berücksichtigen ist, daß die Variationsmöglichkeiten natürlich auch von den anwenderseitig voreingestellten Parametern abhängig ist.

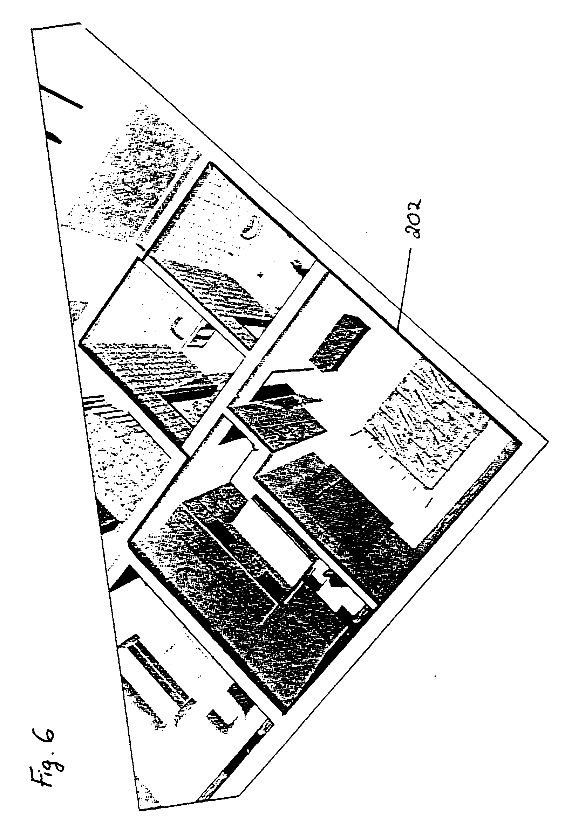

Aus Figur 6 ist eine dreidimensionale Darstellung der bereits im Rahmen der Beschreibung zu Figur 2 diskutierten Wohnung 202 zu sehen, die dem Anwender der erfindungsgemäßen Vorrichtung die Möglichkeit eröffnet auch räumlich eine Vorstellung von dem Wohnraum zu bekommen, den er zu mieten, zu kaufen oder in dieser Form umzubauen beabsichtigt. Ein dreidimensional virtuelle Darstellung liegt natürlich ebenfalls im Rahmen der vorliegenden Erfindung.

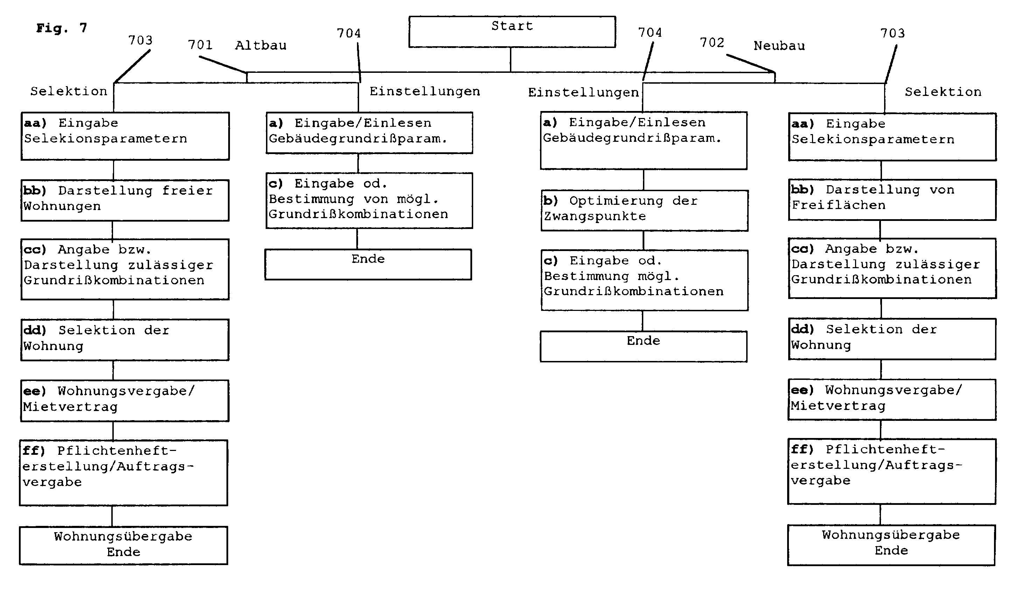

Figur 7 zeigt im wesentlichen die wichtigsten Schritt des durchgeführten Verfahrens im Rahmen der erfindungsgemäßen Vorrichtung. Im Ansatz werden dabei zwei Verfahrenszweige unterschieden, die je nach Anwendungsfall vom Verwender selektiert werden können. Dies ist zum einen der Zweig für Altbauten 701 und der für Neubauten 702. Die durchzuführenden Verfahrenschritte unterscheiden sich, wie aus Figur 7 zu entnehmen ist, nur unwesentlich voneinander. Mit bezug auf die Durchführung des erfindungsgemäßen Verfahrens für Altbauten, aber auch für Neubauten, werden die folgenden Verfahrenschritte unterschieden. Es ist zunächst zwischen der Auswahl der Wohnraumkombinationen 703 und den vorzudefinierenden Grundeinstellungen 704 zu differenzieren. Mit der Eingabe bzw. mit dem Einlesen von Gebäudeparametern im Schritt a) sind im wesentlichen die Einstellungen hinsichtlich der Vorrichtung gemeint, bei denen die Grundrißparameter eingelesen werden, die die Grundrisse der Wohnungen repräsentieren, die im betreffenden Gebäude leer stehen und die einer Vermietung oder einem Verkauf zugeführt werden sollen. In einer einfacheren Ausführung werden dann in Schritt c) extern bestimmte Grundrißvariaten für bestimmte Wohnungen eingelesen und den ursprünglichen Grundrissen des Altbaus als alternative Ausgestaltung zugeordnet. Die Anzahl der Grundrisse bzw. Grundrißkombinationen ist dabei beliebig erweiterbar, wobei auf diese Weise die Flexibilität beliebig erhöht werden kann. Diese Daten stehen dann zur Selektion, gemäß Ablauf nach 703, dem Anwender zur Verfügung. In einer weiteren Ausführungsform werden die Grundrißvariationen in Schritt c) von der Vorrichtung selbst bestimmt und zur Selektion 703 bereitgestellt. Ferner besteht natürlich im Rahmen der Erfindung auch die Möglichkeit auf externe Datenbanken zur Informationsbeschaffung zurückzugreifen. Dabei kann der Benutzer zu Beginn bzw. im ersten Schritt aa) die Parameter eingeben, auf deren Grundlage eine Auswahl erfolgen wird bzw. erfolgen soll. Solche Parameter können beispielsweise sein: Der gewünschten Ort und das betreffende Objekt, der Wohnungstyp, d.h. z.B. Ein-, Zwei- Dreizimmerwohnung, mit oder ohne Balkon, offen oder geschlossen geschnitten, und Daten zur betreffenden Person, etc. Auf der Basis dieser Informationen werden entweder zunächst in Schritt bb) mögliche den Eingabeparmeter entsprechende frei Wohnungen angezeigt und darauf folgend die mögliche Grundrißkombinationen im Schritt cc) aus den Grundeinstellungen ausgewählt und dem Verwender zur Selektion dargeboten oder der Schritt bb) ausgelassen und gleich zum Schritt cc) übergegangen. Wurde vom Benutzer bereits definitive Attributierung des gewünschten Wohnraums vorgenommen und konnte vom System ein entsprechender Grundriß gefunden oder bestimmt werden, so wird im Rahmen der Erfindung eine automatische Selektion durchgeführt. Ansonsten besteht auch die Möglichkeit falls gewünscht oder erforderlich die Auswahl, so wie oben angedeutet, manuell vorzunehmen. In diesem Zusammenhang wird im Rahmen des erfindungsgemäßen Verfahrens entweder die möglichen Grundrisse des potentielle Wohnraums in zweidimensionaler Form oder in dreidimensionaler Perspektive in Schritt cc) dargestellt. Aufbauend auf die Selektion des geeigneten Wohnraums wird im Rahmen des erfindungsgemäßen Verfahrens der Wohnraum in Verfahrensschritt ee) an den Kunden vergeben bzw. verkauft und damit eine Haus- bzw. Wohnungsnummer definiert. Ferner werden im weiteren Verfahrensschritt ff) automatisch die Unterlagen eines Kauf- oder Mietvertrags bereitgestellt und darauffolgenden die Angaben bestimmt auf deren Grundlage ein bautechnisches Pflichtenheft aufbaut. Diese Daten bestehen insbesondere aus Stücklisten, Netzplänen, Balkendiagramme etc. Dabei ist grundsätzlich von einer soweit als möglichen Standardisierung auszugehen. Beispielsweise können solche Standardisierungen sich auf Fertigwandelemente beziehen, die für bestimmte Grundrißvarianten bereits vorgefertigt werden können. Entsprechendes gilt auch für Anschlußelemente bei Wasser Zu- und Abflüssen und bei elektrischen Anschlüssen. Dies bedeutet, daß bereits im Rahmen des Definierens des Pflichtenheftes auf der Grundlage des selektierten Grundrisses in Schritt ff), die für die Umbaumaßnahmen notwendigen Wand- und/oder Installationselemente vorbestimmt werden können, so daß diese von der erfindungsgemäßen Vorrichtung, soweit in den Grundeinstellungen vorhanden, vorgegeben werden können. Der Erfindungsgegenstand erzielt somit ein höchstes Maß an Variabilität und damit Wahlmöglichkeiten mit einem großen Maß an Standardisierung in der nachfolgenden Bauausführung zu verknüpfen. Der Standardisierung ist im Rahmen der Erfindung grundsätzlich keine Grenzen gesetzt. Dies führt nicht zuletzt zu Rüstzeiten von im wesentlichen nur einer Woche und Bauzeit von nur ca. einer Woche.

Der Einsatz der vorliegenden Erfindung mit bezug auf Altbauten 701 hat sich insbesondere bei Plattenbauten als vorteilhaft gezeigt. Plattenbauten weisen in der Regel eine Standardisierung in den Grundrissen auf, welche dem Selektionsmechanismus und der Grundrißstandardisierung des vorliegenden Erfindungsgegenstands entgegen kommt. Es besteht dabei, auf der Basis der erfindungsgemäßen Vorrichtung, die Möglichkeit beispielsweise auch bei zu vermietenden Wohnraum dem zukünftigen Mieter mehrere Varianten eines Wohnungstyps vorzuführen und alle nötigen bautechnischen Maßnahmen in automatisierter Form in die Wege zu leiten. Es ist dadurch auch möglich flexibel auf Zeitströmungen in der Wohnungsgestaltung einzugehen oder anpassungsfähig zu bleiben für Bedarfsänderung auf dem Wohnungsmarkt.

Für Neubauten unterscheidet sich der Verfahrensgang gegenüber Altbauten nur unwesentlich. Bei den Grundeinstellungen steht bei Neubauten innerhalb der Gebäudehülle noch ein weiterer Grundrißparameter und zwar die Zwangspunkte zur Optimierung der Grundrisse zur Verfügung. Dieser Optimierungsprozeß findet beim erfindungsgemäßen Verfahren im Schritt b) der Grundeinstellungen für Neubauten statt. Grundsätzlich ist im Rahmen der Erfindung natürlich ein solcher Optimierungsschritt auch bei Altbauten durchführbar. Eine Optimierung der Zwangspunkt bzw. ein Einbeziehen der Zwangspunkte in das Bereitstellen von Grundrißvarianten, ist jedoch bei Altbauten im allgemeinen aufwendiger und damit häufig auch kostenintensiver. Aufgrund dieser zusätzlichen Optimierungsmöglichkeit, können bei Neubauten mehr Grundrißkombinationen zur Selektion bereitgestellt werden als bei Altbauten.

Ferner unterscheiden sich die Verfahrensschritte bb) für Neu- und Altbauten leicht voneinanderer. Werden bei Altbauten im Verfahrensschritt bb) frei Wohnungen dargestellt, so erfolgt im vorliegendem Ausführsbeispiel bei Neubauten die Darstellung von Freiflächen.

## Patentansprüche

1. Vorrichtung zur Bereitstellung von variablem Nutzraum in Form von digitalen Informationen, Arbeitslisten, Plänen sowie graphischen Darstellungen umfassend:
eine Einrichtung zur Speicherung und Selektion von Daten von Gebäuden,
eine Auswerteeinrichtung zur Bestimmung von Daten architektonischer Varianten von bewohnbaren Bereichen in Gebäuden.

2. Vorrichtung nach Anspruch 1, dadurch gekennzeichnet, daß die Vorrichtung ferner eine Eingabeeinrichtung zur Eingabe der Daten von Gebäuden umfaßt.

3. Vorrichtung nach Anspruch 1 oder 2, dadurch gekennzeichnet, daß die Daten von Gebäuden externe Selektionsparameter als Wohnobjektparameter und interne Grundeinstellungen als Gebäudeparameter, umfassen.

4. Vorrichtung nach Anspruch 3, dadurch gekennzeichnet, daß die Gebäudeparameter Daten zu Zwangspunkten und/oder Grundrisse von Wohnflächen von Gebäuden umfassen.

5. Vorrichtung nach Anspruch 3 oder 4, dadurch gekennzeichnet, daß die Wohnobjektparameter Parameter des Wohnungsstandorts, des Wohnungstyps und der Wohnungsausstattung umfassen.

6. Vorrichtung nach einem der vorhergehenden Ansprüche, dadurch gekennzeichnet, daß die Auswerteeinrichtung eine Mikroprozessoreinrichtung umfaßt, der auf der Basis der Gebäudeparametern und den Wohnobjektparameter Grundrißkombinationen und/oder Ausstattungsvarianten der Wohnung bestimmt.

7. Vorrichtung nach Anspruch 6, dadurch gekennzeichnet, daß die Mikroprozessoreinrichtung der Auswerteeinrichtung Daten eines bauplanerischen Pflichtenheftes bereitstellt.

8. Vorrichtung nach den Ansprüchen 6 oder 7, dadurch gekennzeichnet, daß die Mikroprozessoreinrichtung der Auswerteeinrichtung Daten eines Wohnkaufvertrages oder Wohnmietvertrages bereitstellt.

9. Vorrichtung nach einem der vorhergehenden Ansprüche, dadurch gekennzeichnet, daß die Vorrichtung auch eine Anzeigeeinrichtung zur graphischen Darstellung architektonischer Varianten des Wohnraums umfaßt.

10. Vorrichtung nach Anspruch 9, dadurch gekennzeichnet, daß mittels der Anzeigeeinrichtung die Grundrißkombinationen und/oder Ausstattungsvarianten dreidimensional Darstellung darstellbar sind.

11. Vorrichtung nach einem der vorhergehenden Ansprüche, dadurch gekennzeichnet, daß die Vorrichtung mindestens eine bidirektionale Schnittstelle zur Kommunikation mit externen Computeranlagen umfaßt.

12. Vorrichtung nach einem der vorhergehenden Ansprüche, dadurch gekennzeichnet, daß die Vorrichtung ferner eine Ausgabeeinrichtung zur Ausgabe der graphischen Darstellung der architektonischen Varianten des Wohnraums umfaßt.

13. Verfahren zur Bereitstellung von variablem Wohnraum in Form von digitalen Informationen, Arbeitslisten, Plänen sowie graphischen Darstellungen, insbesondere unter Verwendung einer Vorrichtung gemäß Anspruch 1, gekennzeichnet durch die Verfahrensschritte: Eingabe von Selektionsparametern Darstellung des potentiellen Wohnbereichs Angabe der möglichen Grundrißkombinationen

14. Verfahren nach Anspruch 13, dadurch gekennzeichnet, daß die Selektionsparametern als Wohnobjektparameter den Standort des Objekts und architektonische Merkmale des Objekts umfassen.

15. Verfahren nach den Ansprüchen 13 oder 14, dadurch gekennzeichnet, daß das Verfahren nach dem Schritt cc) ferner den Schritt dd) der automatischen oder manuellen Selektion der Grundrißkombination umfaßt.

16. Verfahren nach einem der vorhergehenden Ansprüchen, dadurch gekennzeichnet, daß das Verfahren den Schritt ee) des Bereitstellens von Daten für einen Kauf- oder Mietvertrags umfassen kann.

17. Verfahren nach einem der vorhergehenden Ansprüche, dadurch gekennzeichnet, daß das Verfahren den Schritt ff) das Bereitstellen der Daten eines bautechnischen Pflichtenheftes umfaßt.

18. Verfahren nach einem der vorhergehenden Ansprüche, dadurch gekennzeichnet, daß vor dem Schritt aa) der Schritt a) der Eingabe und des Einlesens der Grundgrundrißparameter durchgeführt wird.

19. Verfahren nach einem der vorhergehenden Ansprüche, dadurch gekennzeichnet, daß vor dem Schritt aa) und nach dem Schritt a) der Schritt b) der Optimierung der Zwangspunkte durchgeführt wird.

20. Verfahren nach einem der vorhergehenden Ansprüche, dadurch gekennzeichnet, daß nach den Schritten des Anspruchs 19 der Schritt c) des Bestimmens und Zuordnens der Grundrißkombinationen durchgeführt wird.
